# EUROPEAN PATENT APPLICATION

(11) **EP 4 583 402 A2**
(43) Date of publication of application: **09.07.2025**
(21) Application number: 24198489.7
(22) Date of filing: 04.09.2024
(51) Int. Cl.: H03H 3/10, H03H 9/02, H03H 9/145, H03H 9/64

(54) **SAW RESONATOR HAVING HEAVY-METAL ELECTRODES INTERLEAVED WITH TRENCHES IN THE PIEZOELECTRIC MATERIAL**

(30) Priority: 12.09.2023 US 202363582176 P
(71) Applicant: Qorvo US, Inc., Greensboro, NC 27409 (US)
(72) Inventor: RATH, Patrik, Greensboro, 27409 (US)
(74) Representative: D Young & Co LLP

(57) **Abstract**

A surface acoustic wave (SAW) resonator device is provided. The SAW resonator device includes a first electrode positioned on an upper surface of a piezoelectric film. The first electrode may include a plurality of layers wherein a layer of the plurality of layers is a first heavy metal layer. The SAW resonator device may also include a first piezoelectric trench (PZT) positioned adjacent to the first electrode. The first PZT includes a recess in the piezoelectric film.

## Description

### TECHNICAL FIELD

The present disclosure relates generally to acoustic wave resonators. In particular, an acoustic wave resonator may include piezoelectric trenches interleaved between electrodes including a layer of heavy metal to shift and reduce spurious content to reduce interference and increase signal quality.

### BACKGROUND

An acoustic wave (AW) resonator is a device that uses a piezoelectric material to convert between electrical energy and the mechanical vibrations to filter and process electrical signals. AW resonators are commonly used in electronic communication devices. AW resonators are small, low-cost, and highly reliable resonators used for electronic filters for multiplexers which makes them ideal for use in compact electronic devices.

The use of acoustic wave (AW) resonators is widespread in communication applications due to several performance advantages, including low insertion loss, high selectivity, and small size. Aspects of acoustic wave (AW) resonators include bulk acoustic wave (BAW) and surface acoustic wave (SAW) resonators. Designing AW filters with low insertion loss, large enough passband width, good out-of-band rejection, and good isolation requires the technology and resonator geometry to be optimized for sufficient coupling, high quality factor, largely suppressing all spurious mode types as well as reducing loss mechanisms in all three dimensions. Following these principles typically enables construction of AW filters with sufficiently high signal quality by minimizing ripples and loss mechanism in the filter response. Unwanted responses can be caused by the same filter or other filters within a multiplexer circuit. Cleaning up resonator responses in a large frequency range is, therefore, an important goal for improvements over existing AW resonator technology.

### SUMMARY

Embodiments of the present disclosure include devices, systems, and methods for piezoelectric trenches (PZTs) between electrodes that include a heavy metal layer within SAW resonators for increased performance. Aspects of the disclosure advantageously provide significantly reduced interference between filters of multiplexer circuits. In addition, aspects of the disclosure advantageously allow shifting spurious content of a surface acoustic wave resonator higher on the frequency spectrum as well as shift a fundamental resonance frequency lower on the frequency spectrum which may assist designers of various telecommunications circuitry to avoid interference between resonators or filters of circuits resulting in increased performance. In some aspects, SAW resonators with electrodes that include a heavy metal layer as well as piezoelectric trenches between these electrodes advantageously reduces interference, shifts spurious content higher on the frequency spectrum and away from passbands of other resonators or filters within a circuit, and shifts fundamental frequencies lower, to a greater degree than SAW resonators with heavy metal layers or PZTs alone.

In an example aspect, a surface acoustic wave (SAW) resonator device is provided. The SAW resonator device includes a first electrode positioned on an upper surface of a piezoelectric film, the first electrode comprising a plurality of layers wherein a layer of the plurality of layers is a first heavy metal layer; and a first piezoelectric trench (PZT) positioned adjacent to the first electrode, the first PZT including a recess in the piezoelectric film.

In some aspects, the heavy metal layer of the first electrode is made of platinum. In some aspects, the heavy metal layer of the first electrode is made of tungsten. In some aspects, the heavy metal layer of the first electrode is made of gold. In some aspects, the first electrode further comprises a second heavy metal layer. In some aspects, the first heavy metal layer and the second heavy metal layer are separated by a conductive layer. In some aspects, the first PZT is positioned between the first electrode and a second electrode positioned on the upper surface of the piezoelectric film. In some aspects, the SAW resonator device further includes a second electrode including a second heavy metal layer. In some aspects, the second electrode includes a third heavy metal layer. In some aspects, the first PZT is an upper PZT formed within the upper surface of the piezoelectric film. In some aspects, the first PZT is a lower PZT formed within the lower surface of the piezoelectric film. In some aspects, a first trench depth of the first PZT is equal to or less than the thickness of the piezoelectric film. In some aspects, a trench depth equal to the thickness of the piezoelectric film corresponds to a fully-etched PZT. In some aspects, the SAW resonator device further includes a second PZT positioned within the piezoelectric film on a side of the first electrode opposite the first PZT.

In an example aspect, a surface acoustic wave (SAW) resonator device is provided. The SAW resonator device includes a plurality of electrodes positioned on an upper surface of a piezoelectric film of a first thickness, each electrode of the plurality of electrodes comprising at least one heavy metal layer; and a plurality of piezoelectric trenches (PZTs) formed within the piezoelectric film between the plurality of electrodes, wherein the plurality of PZTs correspond to regions of the piezoelectric film of a second thickness less than the first thickness.

In some aspects, the plurality of electrodes are spaced from one another by a first pitch and the plurality of PZTs are spaced from one another by a second pitch. In some aspects, the first pitch is different from the second pitch. In some aspects, the plurality of electrodes are spaced from one another by a modulated pitch, such that a first subset of two or more electrodes are spaced from one another by a first pitch and a second subset of two or more interdigital transducers are spaced from one another by a second pitch.

In an example aspect, a method is provided. The method includes receiving a surface acoustic wave (SAW) resonator device, the device comprising: a piezoelectric film; an interdigital transducer including a plurality of interleaved electrodes positioned on the piezoelectric film, each electrode of the plurality of interleaved electrodes comprising a heavy metal layer; and a sacrificial layer positioned on the plurality of interleaved electrodes; and applying an ion beam to the upper surface of the SAW resonator device such that the sacrificial layer is removed and forming piezoelectric trenches (PZTs) between the plurality of interleaved electrodes.

In some aspects, the method further includes patterning the plurality of interleaved electrodes on the piezoelectric film; and patterning the sacrificial layer on the plurality of interleaved electrodes. In some aspects, the interleaved electrodes and sacrificial material are patterned by sputtering, lithography, and dry etching.

Additional aspects, features, and advantages of the present disclosure will become apparent from the following detailed description.

### BRIEF DESCRIPTION OF THE DRAWINGS

Illustrative embodiments of the present disclosure will be described with reference to the accompanying drawings, of which:
Fig. 1 is a perspective view of a representative surface acoustic wave (SAW) device, according to aspects of the present disclosure.
Fig. 2 is a cross-sectional side view of a SAW resonator with a piezoelectric trench and heavy metal electrodes, according to aspects of the present disclosure.
Fig. 3A is a graphical representation of the absolute value of the admittance of SAW resonators with and without piezoelectric trenches and heavy-metal electrodes, according to aspects of the present disclosure.
Fig. 3B is a graphical representation of the conductance of SAW resonators with and without piezoelectric trenches and heavy-metal electrodes, according to aspects of the present disclosure.
Fig. 3C is a graphical representation of a quality factor of SAW resonators with and without piezoelectric trenches and heavy-metal electrodes, according to aspects of the present disclosure.
Fig. 3D is a graphical representation of dissipated power of SAW resonators with and without piezoelectric trenches and heavy-metal electrodes, according to aspects of the present disclosure.
Fig. 4A is a graphical representation of the absolute value of the admittance of SAW resonators with and without piezoelectric trenches and heavy-metal electrodes normalized to a common resonance frequency, according to aspects of the present disclosure.
Fig. 4B is a graphical representation of a conductance of SAW resonators with piezoelectric trenches and heavy-metal electrodes normalized to a common resonance frequency, according to aspects of the present disclosure.
Fig. 4C is a graphical representation of a quality factor of SAW resonators with piezoelectric trenches and heavy-metal electrodes normalized to a common resonance frequency, according to aspects of the present disclosure.
Fig. 4D a graphical representation of dissipated power of SAW resonators with and without piezoelectric trenches and heavy-metal electrodes normalized to a common resonance frequency, according to aspects of the present disclosure.
Fig. 5A is a graphical representation of the absolute value of the admittance of SAW resonators with and without piezoelectric trenches and heavy-metal electrodes normalized to a common resonance frequency and illustrating extended high-frequency range, according to aspects of the present disclosure.
Fig. 5B is a graphical representation of a conductance of SAW resonators with piezoelectric trenches and heavy-metal electrodes normalized to a common resonance frequency and illustrating extended high-frequency range, according to aspects of the present disclosure.
Fig. 5C is a graphical representation of a quality factor of SAW resonators with piezoelectric trenches and heavy-metal electrodes normalized to a common resonance frequency and illustrating extended high-frequency range, according to aspects of the present disclosure.
Fig. 5D is a graphical representation of dissipated power of SAW resonators with piezoelectric trenches and heavy-metal electrodes normalized to a common resonance frequency and illustrating extended high-frequency range, according to aspects of the present disclosure.
Fig. 6 is a graphical representation of a comparison of the performance of SAW ladder filters including series and parallel resonators, based on resonators with and without piezoelectric trenches and heavy-metal electrodes, according to aspects of the present disclosure.
Fig. 7 is a graphical representation of a comparison of the performance of SAW ladder filters including series and parallel resonators, based on resonators with and without piezoelectric trenches and heavy-metal electrodes illustrating extended high-frequency range, according to aspects of the present disclosure.
Fig. 8A is a graphical representation of a relationship between heavy metal layer thickness, piezoelectric trench depth, and normalized stop band width of a SAW resonator, according to aspects of the present disclosure.
Fig. 8B is a graphical representation of a relationship between heavy metal layer thickness, piezoelectric trench depth, and coupling of a SAW resonator, according to aspects of the present disclosure.
Fig. 8C is a graphical representation of a relationship between heavy metal layer thickness, piezoelectric trench depth, and quality factor of a SAW resonator, according to aspects of the present disclosure.
Fig. 8D is a graphical representation of a relationship between heavy metal layer thickness, piezoelectric trench depth, and capacitance per area of a SAW resonator, according to aspects of the present disclosure.
Fig. 9 is a graphical representation of a plot illustrating ideal piezoelectric trench depth and heavy metal layer thickness, according to aspects of the present disclosure.
Fig. 10 is a cross-sectional side view of a SAW resonator with piezoelectric trenches and heavy metal electrodes wherein the thickness of the heavy metal layers is varied between electrodes, according to aspects of the present disclosure.
Fig. 11 is a cross-sectional side view of a SAW resonator with piezoelectric trenches and heavy metal electrodes wherein the depth of the piezoelectric trenches is modulated, according to aspects of the present disclosure.

### DETAILED DESCRIPTION

For the purposes of promoting an understanding of the principles of the present disclosure, reference will now be made to the embodiments illustrated in the drawings, and specific language will be used to describe the same. It is nevertheless understood that no limitation to the scope of the disclosure is intended. Any alterations and further modifications to the described devices, systems, and methods, and any further application of the principles of the present disclosure are fully contemplated and included within the present disclosure as would normally occur to one skilled in the art to which the disclosure relates. In particular, it is fully contemplated that the features, components, and/or steps described with respect to one embodiment may be combined with the features, components, and/or steps described with respect to other embodiments of the present disclosure. For the sake of brevity, however, the numerous iterations of these combinations will not be described separately.

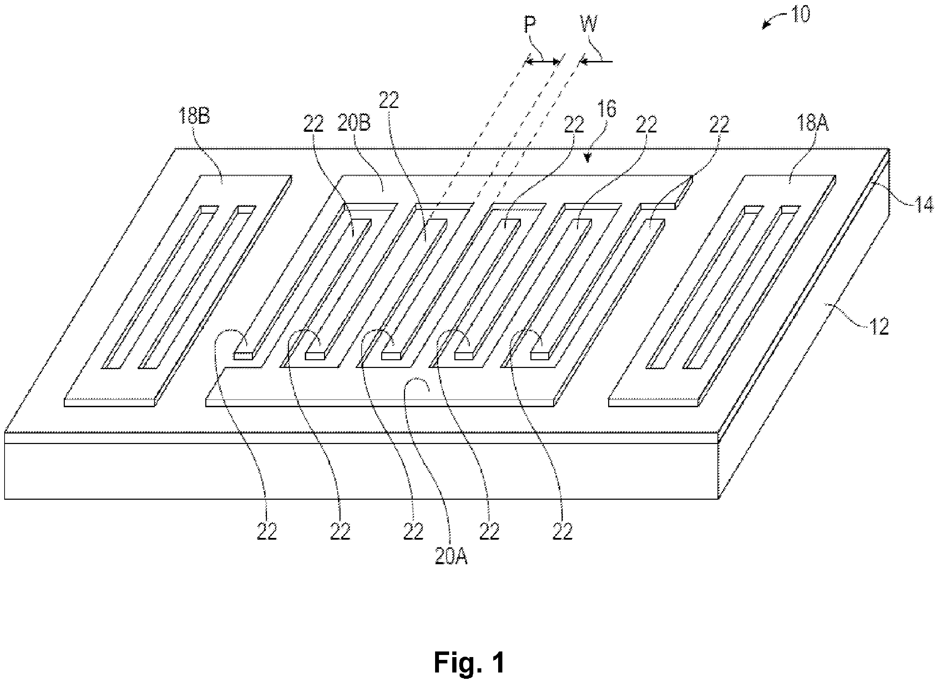

Example embodiments of the present disclosure relate to SAW resonators with electrodes including heavy metal layers and piezoelectric trenches (PZTs) between the electrodes. In some aspects, guided SAW type technologies have high quality factor, high coupling, and low TCF. In some aspects, a SAW resonator, such as the one shown and described in Fig. 1 may additionally be referred to as an LRT-SAW, multi-layer SAW, thin film SAW, or any other suitable term. Any of these terms may be used in the present disclosure and are not intended to be limiting. A key improvement point for this type of technology is to reduce existing loss mechanisms and spurious acoustic modes. For challenging applications, these can currently impact in-band and near-band performance (e.g., limited stop band width, limited distance to the bulk wave onset of the carrier substrate), as well as impact out-of-band specifications and make multiplexing with other filters challenging. The techniques disclosed herein improve upon these major challenges of guided SAW type technologies.

Fig. 1 is a perspective view of a representative surface acoustic wave (SAW) device, according to aspects of the present disclosure. While this disclosure describes principles of the techniques in the context of a SAW resonator, it should be understood that the technology presented may be applied to any suitable type of acoustic wave (AW) resonator, including SAW resonators and BAW resonators equally. It particularly can be applied to any AW resonator that employs interdigital transducer electrodes, for various orientations of the acoustic wave propagation and the displacements with respect to the arrangement of the electrodes. The SAW device 10 includes a substrate 12, a piezoelectric layer 14 on the substrate 12, an interdigital transducer (IDT) 16 including electrodes 22 on a surface of the piezoelectric layer 14 opposite the substrate 12, a first reflector structure 18A on the surface of the piezoelectric layer 14 adjacent to the interdigital transducer 16, and a second reflector structure 18B on the surface of the piezoelectric layer 14 adjacent to the interdigital transducer 16 opposite the first reflector structure 18A. In some aspects, an interdigital transducer may also be referred to as an interdigitated transducer. In certain aspects, the substrate 12 may be referred to as a carrier substrate and the overall SAW device 10 may be referred to as a guided SAW device.

The interdigital transducer 16 includes a first electrode 20A and a second electrode 20B, each of which include a number of electrodes 22 that are interleaved with one another as shown. The first electrode 20A and the second electrode 20B may also be referred to as comb electrodes. A lateral distance between adjacent electrodes 22 of the first electrode 20A and the second electrode 20B defines a pitch P between adjacent electrodes 22. The pitch P may at least partially define a resonant frequency of the corresponding electrode(s) 22. In that regard, in embodiments in which the pitch P between electrodes 22 is uniform, all electrodes 22 may be configured to correspond to the same resonant frequency. This resonant frequency may be the resonant frequency of the SAW device 10. A resonant frequency may be the center frequency or primary frequency of mechanical waves generated in the piezoelectric layer 14 by one or more electrodes 22. An electrode width W of the adjacent electrodes 22 together with the pitch P may define a metallization ratio, or duty factor, of electrodes 22.

In operation, an alternating electrical input signal provided at the first electrode 20A is transduced into a mechanical signal in the piezoelectric layer 14, resulting in one or more acoustic waves therein. In the case of the SAW device 10, the resulting acoustic waves are predominately surface acoustic waves. As discussed above, due to the pitch P and the metallization ratio of the interdigital transducer 16, the characteristics of the material of the piezoelectric layer 14, and other factors, the magnitude and frequency of the acoustic waves transduced in the piezoelectric layer 14 are dependent on the frequency of the alternating electrical input signal. This frequency dependence is often described in terms of changes in the impedance and/or a phase shift between the first electrode 20A and the second electrode 20B with respect to the frequency of the alternating electrical input signal. An alternating electrical potential between the two electrodes 20A and 20B creates an electrical field in the piezoelectric material which generates acoustic waves. The acoustic waves travel at the surface and eventually are transferred back into an electrical signal between the electrodes 20A and 20B. The first reflector structure 18A and the second reflector structure 18B reflect the acoustic waves in the piezoelectric layer 14 back towards the interdigital transducer 16 to confine the acoustic waves in the area surrounding the interdigital transducer 16. The substrate 12 may comprise various materials including glass, sapphire, quartz, diamond, silicon (Si), or gallium arsenide (GaAs) among others, with Si being a common choice. The piezoelectric layer 14 may be formed of any suitable piezoelectric material(s). In certain embodiments described herein, the piezoelectric layer 14 is formed of lithium tantalate (LT), or lithium niobate (LiNb03 or LN), but is not limited thereto. In certain embodiments, the piezoelectric layer 14 is thick enough or rigid enough to function as a piezoelectric substrate. Accordingly, the substrate 12 in FIG. 1 may be omitted. Those skilled in the art will appreciate that the principles of the present disclosure may apply to other materials for the substrate 12 and the piezoelectric layer 14. The interdigital transducer 16, the first reflector structure 18A, and the second reflector structure 18B may comprise one or more electrically conductive materials, including titanium (Ti), aluminum (Al), copper (Cu), and alloys thereof as well as alloys with other suitable materials and can be made of either single or multiple layer arrangements, among others. While not shown to avoid obscuring the drawings, additional dielectric layers or any other layers may be provided over all or a portion of the exposed surface of the piezoelectric layer 14, the interdigital transducer 16, the first reflector structure 18A, and the second reflector structure 18B. Such additional passivation layers can form any surface topography, including but not limited to conformal coatings and flat surfaces. Such additional dielectric layers may be provided for passivation, for frequency trimming, for temperature compensation purposes and/or improved thermal conductivity, among other reasons. Suitable materials for such layers include silicon oxide, silicon nitride, titanium oxide, aluminum oxide and can also include dopants such as fluorine. Further, one or more layers may be provided between the substrate 12 and the piezoelectric layer 14 in various embodiments.

In some aspects, a SAW resonator, such as the one shown and described in Fig. 1 may additionally be referred to as a guided SAW, LRT-SAW, multi-layer SAW, thin film SAW, or any other suitable term.

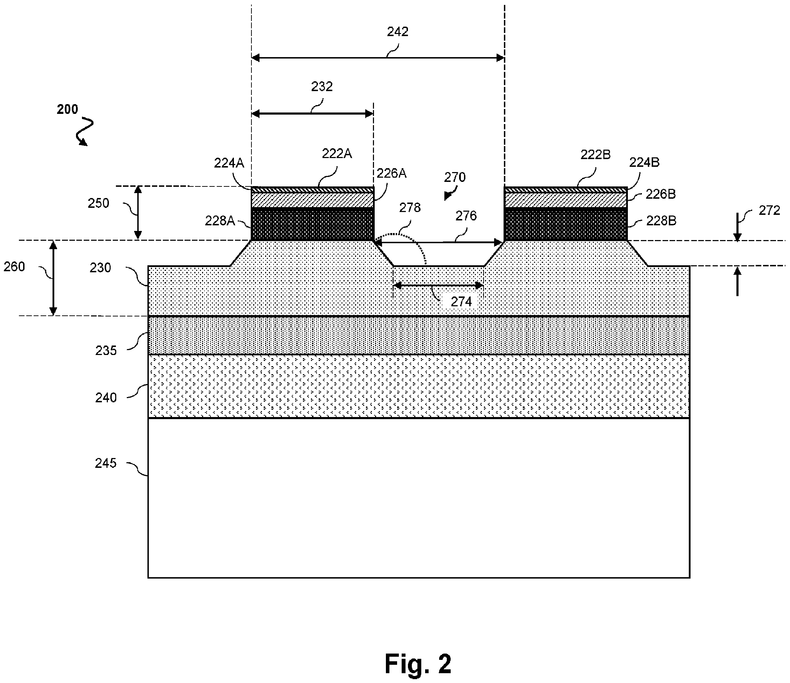

Fig. 2 is a cross-sectional side view of a SAW resonator 200. The SAW resonator 200 comprises various components including a carrier substrate 245, a dielectric layer 240, a dielectric layer 235, a piezoelectric film 230, and two electrodes 222A and 222B.

The carrier substrate 245 forms the foundation of the SAW resonator 200 and provides structural support to the device. It can be made from a variety of materials including glass, silicon, silicon carbide, quartz, diamond, sapphire, or any other suitable material. In certain embodiments, the carrier substrate 245 may be selected based on its mechanical, thermal, or electrical properties to meet the requirements of a specific application.

The dielectric layer 240 is positioned on top of the carrier substrate 245 and provides electrical insulation between the carrier substrate 245 and the rest of the SAW resonator 200. In some aspects, the dielectric layer 240 may additionally provide a velocity contrast to the piezoelectric layer to help with guiding the wave localized mainly in the piezoelectric layer. The dielectric layer 240 may additionally help to avoid losses due to overlap with the carrier material as well as reduce TCF. The dielectric layer 240 may be made from a variety of materials including silicon dioxide, silicon oxide, silicon nitride, or aluminum oxide, or any other material, depending on the requirements of the specific application.

In some aspects, the dielectric layer 240 may alternatively be a trap rich layer (TRL). A TRL may, for example, be silicon-based such as poly-crystalline silicon or an implanted layer close to the top surface of the carrier wafer itself.

The dielectric layer 235 is positioned on top of the dielectric layer 240 and serves as a second layer of electrical insulation. It can also be made from a variety of materials including any of those described with reference to layer 240. In some aspects, a resonator may include any suitable number of dielectric layers in any suitable arrangement.

The piezoelectric film 230 is positioned on top of the dielectric layer 235 and transduces electrical energy into mechanical energy. The piezoelectric film 230 can be made from a variety of materials including lithium tantalate, lithium niobate, zinc oxide, aluminum nitride, scandium aluminum nitride, or any other materials. In operation, the piezoelectric film 230 is excited by the electrodes 222A and 222B to produce acoustic waves. A common choice for the piezoelectric layer may be of a thickness less than five times the wavelength lambda of the acoustic wave. Often it is advantageous to have thickness of less than one wavelength and could be between 5% and 60% of the wavelength, while the techniques disclosed here are not limited to these examples. A common choice for the piezoelectric material may be lithium tantalate, with an orientation typically between Y+0° and Y+60° and a propagation along the x-axis of the crystal. Orientations close to 42° Y-X LT are a common choice, while orientations close to 30° Y-X LT can in some cases lead to minimized excitation of Rayleigh-type spurious acoustic modes. Another common choice for the piezoelectric material may be lithium niobate, with an orientation typically between Y-20° and Y+60° and a propagation along the x-axis of the crystal. Orientations close to 10° Y-X LN and 20° Y-X LN may be implemented, but are not limiting. A large coupling coefficient can be obtained. In these piezoelectric layers, the devices primarily excite waves with shear horizontal displacements, while the techniques disclosed here are not limited to optimization concerning this wave type.

The electrodes 222A and 222B are positioned on top of the piezoelectric film 230 and excite the piezoelectric film 230. The transducers 222A and 222B are transducers within a series of alternating and/or interleaved fingers (see, for example, electrodes 22 of Fig. 1). In operation, one of the transducers 222A or 222B may be connected to a positive electrical potential while the other is connected to a negative potential, resulting in the production of acoustic waves in the piezoelectric film 230. The transducers 222A and 222B each include a plurality of layers, as illustrated in Fig. 2.

In some embodiments, the electrode 222A may include a layer 224A, a layer 226A, and a layer 228A. However, the electrode 222A, as well as any other electrodes (e.g, electrode 222B, or any other electrode) may alternatively include any suitable number or types of layers in addition to or alternative to the layers shown and described with reference to Fig. 2. Like the electrode 222A, the electrode 222B may include a layer 224B, a layer 226B, and a layer 228B. For purposes of the present disclosure, the layers 228A and 228B will be described together with reference to the layer 228. Similarly, layers 226A and 226B and layers 224A and 224B will be explained in conjunction.

In some aspects, the layer 228 may facilitate adhesion to the wafer, to avoid migration of atoms (into the substrate and along the surface) and to lead to suitable crystallinity of the layers above. The layer 228 may be a heavy metal. In that regard, the layer 228 may be referred to as a heavy metal layer. In some aspects, an electrode that includes at least one heavy metal layer may be referred to as a heavy metal electrode. The layer 228 may be constructed of any suitable heavy metal. For example, the layer 228 may be constructed of Osmium, Iridium, Platinum, Rhenium, Gold, Tungsten, Tantal, Hafnium, Rhodium, Ruthenium, Thallium, Lead, Silver, Molybdenum, Palladium and alloys containing one or more of the mentioned materials.

Though not illustrated in Fig. 2, in some aspects, each electrode 222 may include an additional layer positioned beneath the heavy metal layers 228. For example, this additional layer may be a thin layer that may provide adhesion, or suitable crystallinity of any of the other layers. This thin layer provided beneath the heavy metal layers 228 may be constructed of a titanium layer or any other suitable material.

In some aspects, because the layer 228 is constructed of a heavy metal, the velocity of the acoustic wave generated by the SAW resonator 200 may be decreased. In addition, the reflectivity of the SAW resonator 200 may be increased. These effects may be modified by varying the thickness of the layer 228. In some aspects, as the thickness of the layer 228 is increased, the quality factor of the SAW resonator 200 may begin to decrease introducing insertion loss. This may be a result of increasing overlap of the acoustic wave mode with intrinsically lossy metallic materials.

As described in more detail hereafter, the velocity of the acoustic wave of the SAW resonator 200 may be decreased and the reflectivity of the SAW resonator 200 may be increased alternatively by increasing the depth of the piezoelectric trenches (PZTs) 270 positioned between the electrodes 222. Like the heavy metal layer 228, increasing the depth of the PZTs 270 may decrease wave velocity and increase reflectivity. However, as the depth is increased to a point, the quality factor of the resonator 200 may begin to decrease. In that regard, when the thickness of the heavy metal layer is increased while still maintaining sufficient quality factor, PZTs 270 may be introduced and/or deepened to further reduce wave velocity and increase reflectivity without negatively impacting the quality factor of the resonator 200. This advantageously increases resonator performance. In that regard, while the introduction of piezoelectric trenches may, by themselves decrease wave velocity and increase reflectivity of a resonator and while the inclusion of a heavy metal layer may also independently decrease wave velocity and increase reflectivity, the current state of the art has not included both of these features (i.e., PZTs and heavy metal layers) in the same resonator for a number of reasons.

First, as the depth of piezoelectric trenches are designated during the design of a SAW resonator, persons of skill in the art have traditionally assumed that once the quality factor of the resonator begins to decrease as the depth of piezoelectric trenches is increased, that any design changes to further decrease wave velocity will have the same effect as increasing the depth of the piezoelectric trenches (i.e., decreasing quality factor) and are not implemented. Similarly, as the thickness of heavy metal layers are designated during the design of a SAW resonator, persons of skill in the art have traditionally assumed that once the quality factor of the resonator begins to decrease as the thickness of the heavy metal layers is increased, that any design changes to further decrease wave velocity will have the same effect (i.e., decreasing quality factor) as increasing the thickness of the heavy metal layers and are not implemented. As a result, persons of ordinary skill in the art have been generally dissuaded from implementing both PZTs and heavy metal layers in electrodes of SAW resonator devices.

In addition, to the extent that persons of skill in the art would have considered combining PZTs and heavy metal layers in electrodes of SAW resonator devices, the combined effect was not expected, as will be explained in more detail hereafter.

The layer 226 may be constructed of an electrical conductor (e.g., copper or aluminum). The layer 226 may ensure a small resistance and low electric losses in the IDT fingers. In some aspects, the layer 224 may provide adhesion of additional metal layers (e.g. underbump metals for routing) and may help to prevent oxidation and degradation of the layers below. In some aspects, the electrodes 222 may include additional barrier layers or stacks of layers for the similar purposes including to lower sheet resistance, lower mechanical damping, or increased robustness to withstand environmental conditions such as moisture or excitation under high power.

The layer 224 may be constructed of any suitable material. In some aspects, the layer 224 may be a sacrificial layer, which may be partially or entirely removed during a trim without passivation ("trim without PAS") procedure.

The SAW resonator 200 also illustrates a piezoelectric trench (PZT) 270. In some aspects, the PZT 270 may be formed with a trim without PAS procedure after the SAW resonator 200 is assembled. In some aspects, the PZT 270 may be formed in any other way. In some aspects, a trim without PAS procedure includes removing material from the SAW resonator 200 with an ion beam. The ion beam may be a beam of charged particles, such as ions, that are accelerated and focused to areas of a resonator using lithography techniques. The ion beam can be scanned across the surface of the resonator to selectively remove material. By varying the angle of the ion beam, the shape of the resonator can be altered. Additionally, a trim without PAS procedure can also be applied to the reflectors 18A and 18B of the SAW resonator 200. The reflectors 18A and 18B may also be referred to as gratings.

According to one manufacturing process of the SAW resonator 200-2, the resonator may first be designed with a fundamental resonance frequency that is higher than the desired fundamental resonance frequency. In some aspects, a trim without PAS procedure may be performed on the SAW resonator 200. The geometry of the SAW resonator 200 shown in Fig. 2 may be a resulting cross-sectional shape of the SAW resonator 200. By this process, the fundamental resonance frequency may be shifted downward to a desired fundamental resonance frequency. By adjusting the properties of the ion beam and the scan parameters during the trim without PAS procedure, the fundamental resonance frequency can be precisely controlled to achieve the desired frequency.

As shown in Fig. 2, the PZT 270 may be configured according to any suitable geometry. In the example shown in Fig. 2, the PZT 270 may include tapered edges or shoulders. Specifically, the PZT 270 includes a lower PZT width 274 and an upper PZT width 276. In the example shown, the upper PZT width 276 may be greater than the lower PZT width 274. As a result, shoulders on either side of the PZT 270 are formed. These shoulders may be sloped regions extending from the top surfaces of the piezoelectric film 230 to the lower surface of the PZT 270. In some aspects, the shoulders of the PZT 270 may be sloped according to the angle 278. In some aspects, the sloped shoulders may be symmetrical about a central axis of the PZT 270. In other aspects, the PZT 270 may not be symmetrical. For example, one side of the PZT 270 may be sloped more steeply than the other side or vice versa. Any suitable geometry of the PZT 270 may be used.

As shown in Fig. 2, the PZT 270 may be of a depth 272 while the total thickness of the piezoelectric film 230 may be a thickness 260. In some aspects, performance of the SAW resonator 200 may be dependent, at least in part, on the relationship between the depth 272 of the PZT 270 and the thickness 260 of the piezoelectric film 230. In some aspects, this relationship may be quantified as a percentage of the depth 272 of the thickness 260 or a ratio between the two.

As also shown in Fig. 2, the electrodes 222 may be of a thickness 250. The width of the electrodes 222 may be a width 232 and the electrodes 222 may be spaced according to a pitch 242. While not shown to avoid obscuring the drawings, additional layers be provided over all or a portion of the piezoelectric surface, within the PZT or and/or on top of the electrodes. This may include dielectric layers which may serve for temperature compensation, passivation, frequency trimming or other purposes.

As explained below, the performance of the SAW resonator 200 is greatly improved over standard SAW resonators that do not include electrodes with heavy metal layers (i.e., heavy metal electrodes) or PZTs.

In some aspects, the electrodes 222 of the SAW resonator 200 may include multiple heavy metal layers. For example, although the electrode 222A shown in Fig. 2 includes a single heavy metal layer 228A, the electrode 222A may alternatively include multiple heavy metal layers. For example, multiple heavy metal layers may be separated within the stack by conductive layers similar to the layer 226A. In that regard, each heavy metal layer may individually contribute to slowing of the wave, while the heavy metal layer closest to the piezoelectric surface would contribute more to ensuring high quality factor of the resonator (due to less damping, higher material Q of that layer) as well as contributing more to reliability making it less prone to acousto-migration, while the other heavy metal layers higher in the stack could fulfill other additional purposes, such as contributing partially to improved electrical conductivity.

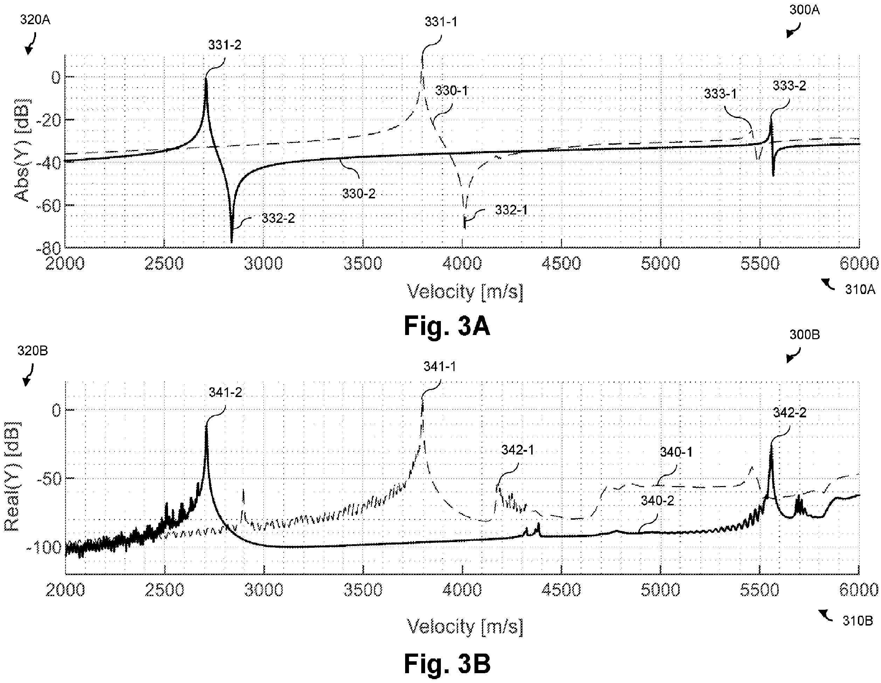

Fig. 3A is a graphical representation of the absolute value of the admittance of SAW resonators with and without piezoelectric trenches and heavy-metal electrodes, according to aspects of the present disclosure. Fig. 3A includes a plot 300A. The plot 300A may include an x-axis 310A corresponding to frequency and a y-axis 320A corresponding to admittance. As shown in the plot 300A, the data set 330-1 represents the admittance of a SAW resonator that does not include heavy metal electrodes or PZTs. The data set 330-2 represents the frequency response of a SAW resonator that does include both heavy metal electrodes and PZTs (such as the SAW resonator 200 (Fig. 2)). Both data sets exhibit a resonance frequency 331 and an anti-resonance frequency 332. The resonance frequency 331 represents the frequency at which the SAW resonator has maximum admittance, while the anti-resonance frequency 332 represents the frequency at which the SAW resonator has minimum admittance.

The resonance frequency 331-2 and the anti-resonance frequency 332-2 (both corresponding to a SAW resonator with both heavy metal electrodes and PZTs) are shifted dramatically lower along the frequency spectrum as compared to the resonance frequency 331-1 and the anti-resonance frequency 332-1.

Fig. 3A additionally shows spurious content 333-1 and 333-2. It is to be noted that the response of resonators with heavy metal electrodes and PZTs as well as the response of resonators without heavy metal electrodes or PZTs exhibit a similar pattern. The resonance and anti-resonance frequencies of the data set 330-2 are shifted lower than those of the data set 330-1 by a similar amount. The frequency shift may depend on factors such as the type of ion beam used for a trim without PAS procedure, the angle of incidence, the duration of the trim, the type of heavy metal of the heavy metal electrodes, and thickness of the heavy metal layer. While the resonance 331-2 and antiresonance 332-2 are shifted downward in frequency relative to the resonance 331-1 and antiresonance 331-2, the spurious content 333-2 is actually shifted upwards in frequency relative to the spurious content 333-1. This advantageously provides a wider usable frequency band. This change in the frequency response, both of the resonance and antiresonance as well as the spurious content, can be used to optimize the SAW resonator design and improve its performance. The frequency shift can be used to adjust the resonance frequency of the SAW resonator to a desired value. This can be particularly useful in applications such as filters, where a precise frequency response is required.

Fig. 3B is a graphical representation of the conductance of SAW resonators with and without piezoelectric trenches and heavy-metal electrodes, according to aspects of the present disclosure. Fig. 3B includes a plot 300B. The plot 300B may include an x-axis 310B corresponding to frequency and a y-axis 320B corresponding to conductance. As shown in the plot 300B, the data set 340-1 represents the conductance of a SAW resonator that does not include heavy metal electrodes or PZTs, while the data set 340-2 represents the conductance of a SAW resonator that does include both heavy metal electrodes and PZTs (such as the SAW resonator 200 (Fig. 2)). Both data sets show a resonance frequency 341 and spurious content 342. The resonance frequency 341 in both data sets may correspond to the respective resonance frequencies 331 described with reference to Fig. 3A.

Similar to the shift in resonance frequencies described with reference to Fig. 3A, the resonance frequency 341-2 is shifted lower than the resonance frequency 341-1. However, the spurious content 342-2 may be shifted higher along the frequency spectrum than the spurious content 342-1. As shown, this shift lower in the fundamental resonance frequency and shift higher of the spurious content may result in a wider band between these two features. This may advantageously allow the resonator to interfere less with the passband of a filter, such as a ladder filter any other suitable circuit that contains this resonator, as well as interfere less with the performance of filters at common ports.

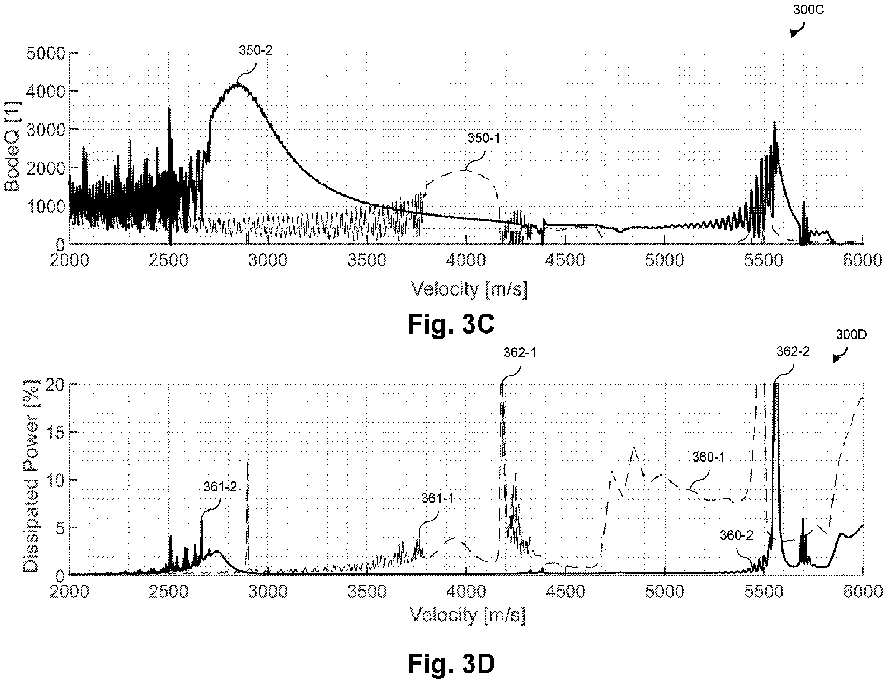

Fig. 3C is a graphical representation of a quality factor of SAW resonators with and without piezoelectric trenches and heavy-metal electrodes, according to aspects of the present disclosure. Fig. 3C includes a plot 300C. The plot 300C includes a data set 350-1 and a data set 350-2. In some aspects, the data set 350-1 may be a data set corresponding to a frequency response of a SAW resonator that does not include heavy metal electrodes or PZTs. The data set 1750-2 may be a data set corresponding to the SAW resonator that does include both heavy metal electrodes and PZTs (such as the SAW resonator 200 (Fig. 2)).

As shown in Fig. 3C, the quality factor of the SAW resonator of the data set 350-2 is greater than the quality factor of the data set 350-1. In some aspects, an increase in the quality factor of a SAW resonator may correspond to a reduced loss of the SAW resonator. In some aspects, this reduced loss may be a result of acoustic energy being located further away from the metal electrodes. In that regard, the more the trench depth is increased and/or the thicker the heavy metal layer of one or more heavy metal electrodes, the more the quality factor is improved.

Fig. 3D is a graphical representation of dissipated power of SAW resonators with and without piezoelectric trenches and heavy-metal electrodes, according to aspects of the present disclosure. The dissipated power may also be referred to as absorbed power. Fig. 3D includes a plot 300D. The plot 300D includes a data set 360-1 and a data set 360-2. In some aspects, the data set 360-1 may be a data set corresponding to a frequency response of a SAW resonator that does not include heavy metal electrodes or PZTs. The data set 360-2 may be a data set corresponding to the SAW resonator that does include both heavy metal electrodes and PZTs (such as the SAW resonator 200 (Fig. 2)).

In some aspects, the data set 360-1 includes a peak 361-1 and a peak 362-1. The data set 360-2 includes a peak 361-2 and a peak 362-2.

As shown in Fig. 3D, as the depth of the PZT is increased and/or as the thickness of the heavy metal layer of a heavy metal electrode is increased, the peak corresponding to the upper stop band edge (e.g., peak 362-2) may be moved higher along the frequency spectrum.

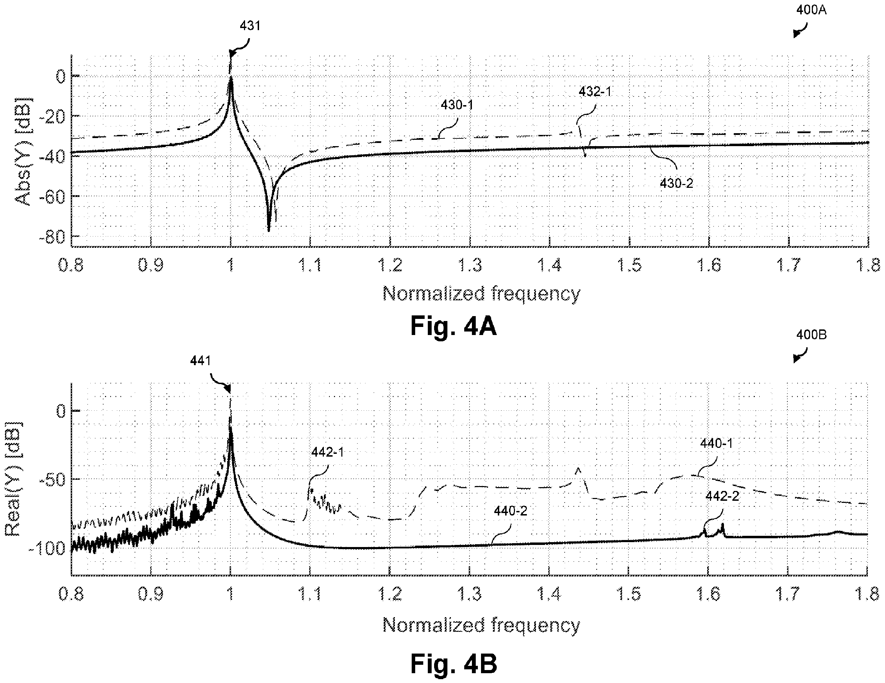

Fig. 4A is a graphical representation of the absolute value of the admittance of SAW resonators with and without piezoelectric trenches and heavy-metal electrodes normalized to a common resonance frequency, according to aspects of the present disclosure.

As described previously, the inclusion of a PZT as well as the inclusion of a heavy metal layer within an electrode of a SAW resonator may result in a decrease in the fundamental resonance frequency. To compensate for the shift in fundamental resonance frequency, the SAW resonator may be selected such that, after any necessary trim without PAS procedures, the final resonance frequency corresponds to the desired target resonance frequency. Or, in other aspects, the SAW resonator may be designed to include PZTs and heavy metal layers as explained and designed to the desired resonance frequency. To illustrate the effect of the PZTs and heavy metal layers of SAW resonators of the same fundamental frequency, the data of Figs. 4Aa-4d may be normalized about the fundamental resonance frequency.

In that regard, Fig. 4A includes a plot 400A. The plot 400A includes a data set 430-1 and a data set 430-2. In some aspects, the data set 430-1 may be a data set corresponding to a frequency response of a SAW resonator that does not include heavy metal electrodes or PZTs. The data set 430-2 may be a data set corresponding to a frequency response of a SAW resonator that does include both heavy metal electrodes and PZTs (such as the SAW resonator 200 (Fig. 2)).

As shown in Fig. 4A, each of the datasets 430-1 and 430-2 include a peak 431 aligned about the normalized fundamental frequency. Each of the datasets 430-1 and 430-2 also include an anti-resonance frequency. As shown, the anti-resonance frequencies may not be aligned with one another, but may be similar. This may result in a slight decrease in effective coupling coefficient of the SAW resonator.

Fig. 4A also shows how the overall amplitude of the datasets 430-1 and 430-2 decreases as the PZT depth increases and/or as the thickness of the heavy metal layer increases. This may indicate a decrease in capacitance of the SAW resonator.

Fig. 4B is a graphical representation of a conductance of SAW resonators with piezoelectric trenches and heavy-metal electrodes normalized to a common resonance frequency, according to aspects of the present disclosure. Fig. 4B includes a plot 400B. The plot 400B includes a data set 440-1 and a data set 440-2. In some aspects, the data set 440-1 may be a data set corresponding to a frequency response of a SAW resonator that does not include heavy metal electrodes or PZTs. The data set 440-2 may be a data set corresponding to the SAW resonator that does include both heavy metal electrodes and PZTs (such as the SAW resonator 200 (Fig. 2)).

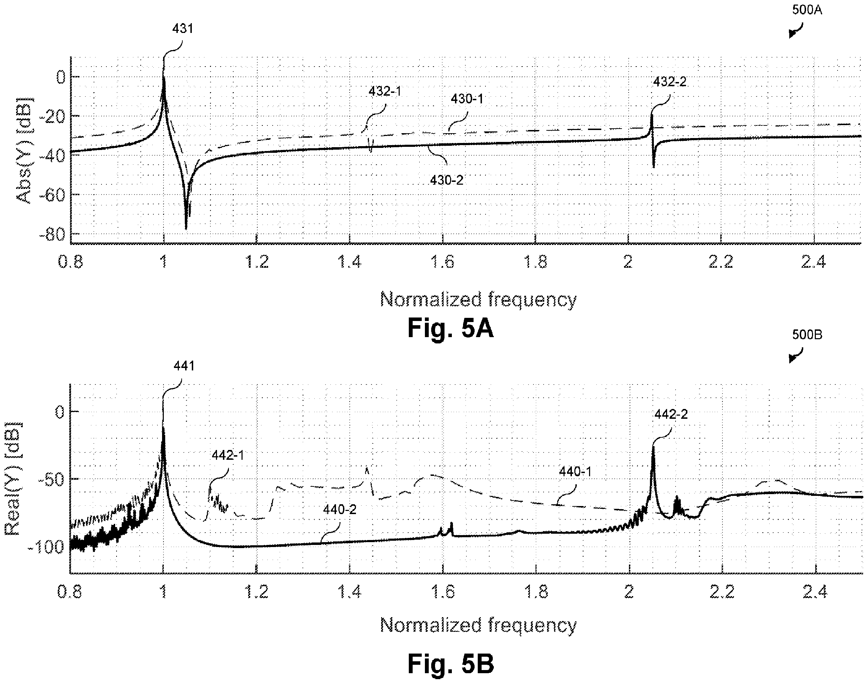

Like the plot 400A, the data sets of the plot 400B are normalized about the resonance frequency for comparison. As a result, the peak 441 of each of the datasets 440-1 and 440-2, is aligned about the central normalized frequency. Fig. 4B illustrates a peak 442-1 corresponding to the upper stop band edge of the SAW resonator corresponding to the data set 440-1. The peak 442-1 will be described in more detail, particularly in comparison with a peak 442-2 hereafter with reference to Fig. 5B. However, it is noted, that the amplitude of the conductance of the data set 440-2 above the peak 441 is less than the amplitude of the conductance of the data set 440-1 above the peak 441, which may contribute to improved performance of the SAW resonator with PZTs and heavy metal layers.

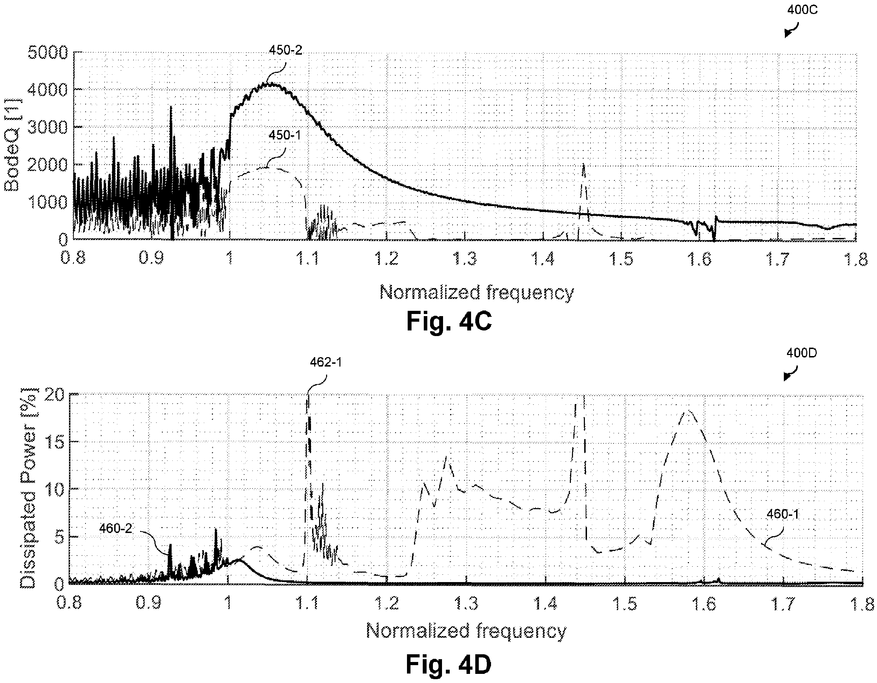

Fig. 4C is a graphical representation of a quality factor of SAW resonators with piezoelectric trenches and heavy-metal electrodes normalized to a common resonance frequency, according to aspects of the present disclosure. Fig. 4C includes a plot 400C. The plot 400C includes a data set 450-1 and a data set 450-2. In some aspects, the data set 450-1 may be a data set corresponding to a frequency response of a SAW resonator that does not include heavy metal electrodes or PZTs. The data set 450-2 may be a data set corresponding to the SAW resonator that does include both heavy metal electrodes and PZTs (such as the SAW resonator 200 (Fig. 2)).

Like the plot 400A, the data sets of the plot 400C are normalized about the resonance frequency for comparison. As shown in Fig. 4C, the quality factor of the SAW resonator of the data set 450-2 is greater than the quality factor of the data set 450-1. In some aspects, an increase in the quality factor of a SAW resonator may correspond to a reduced loss of the SAW resonator. In some aspects, this reduced loss may be a result of acoustic energy being located further away from the metal electrodes. In that regard, the more the trench depth is increased and/or the thicker the heavy metal layer of one or more heavy metal electrodes, the more the quality factor is improved.

Fig. 4D a graphical representation of dissipated power of SAW resonators with and without piezoelectric trenches and heavy-metal electrodes normalized to a common resonance frequency, according to aspects of the present disclosure. The dissipated power may also be referred to as absorbed power. Fig. 4D includes a plot 400D. The plot 400D includes a data set 460-1 and a data set 460-2. In some aspects, the data set 460-1 may be a data set corresponding to a frequency response of a SAW resonator that does not include heavy metal electrodes or PZTs. The data set 460-2 may be a data set corresponding to the SAW resonator that does include both heavy metal electrodes and PZTs (such as the SAW resonator 200 (Fig. 2)).

Like the plot 400A, the data sets of the plot 400D are normalized about the resonance frequency for comparison. As shown in Fig. 4D, the dissipated power of the data set 460-2 is significantly improved over the dissipated power of the data set 460-1.

Fig. 5A is a graphical representation of the absolute value of the admittance of SAW resonators with and without piezoelectric trenches and heavy-metal electrodes normalized to a common resonance frequency and illustrating extended high-frequency range, according to aspects of the present disclosure. Fig. 5A includes a plot 500A. Plot 500A may be substantially similar to plot 400A of Fig. 4A. For example, plot 500A may include more high frequency content of the same data. In that regard, plot 500A may additionally illustrate spurious content 432-2. As shown, due to the PZTs and heavy metal layers of the SAW resonator corresponding to the data set 430-2, spurious content 432-2 may be shifted dramatically higher in frequency than spurious content 432-1.

Fig. 5B is a graphical representation of a conductance of SAW resonators with piezoelectric trenches and heavy-metal electrodes normalized to a common resonance frequency and illustrating extended high-frequency range, according to aspects of the present disclosure. Fig. 5B includes a plot 500B. Plot 500B may be substantially similar to plot 400B of Fig. 4B. For example, plot 500B may include more high frequency content of the same data.

In some aspects, the data set 440-1 includes a peak 442-1, as described with reference to Fig. 4A. However, as shown in the extended range of plot 500B, the data set 440-2 includes a peak 442-2. In some aspects, as the depth of the PZT is increased and/or as the thickness of the heavy metal layer is increased, the peak corresponding to the upper stop band edge may be moved higher along the frequency spectrum. The degree to which this shift in the upper stop band edge occurs is shown more clearly by the plot 500B of Fig. 5B as the fundamental frequency has been normalized. As shown, the peak 442-2 corresponding to a SAW resonator with PZTs and heavy metal layers is significantly higher in frequency than the peak 442-1. This shifting of the upper stop band edge may move spurious content out of the passband of the frequency as well as out of passbands of other filters leading to significantly increased signal quality and performance of multiplexer circuits.

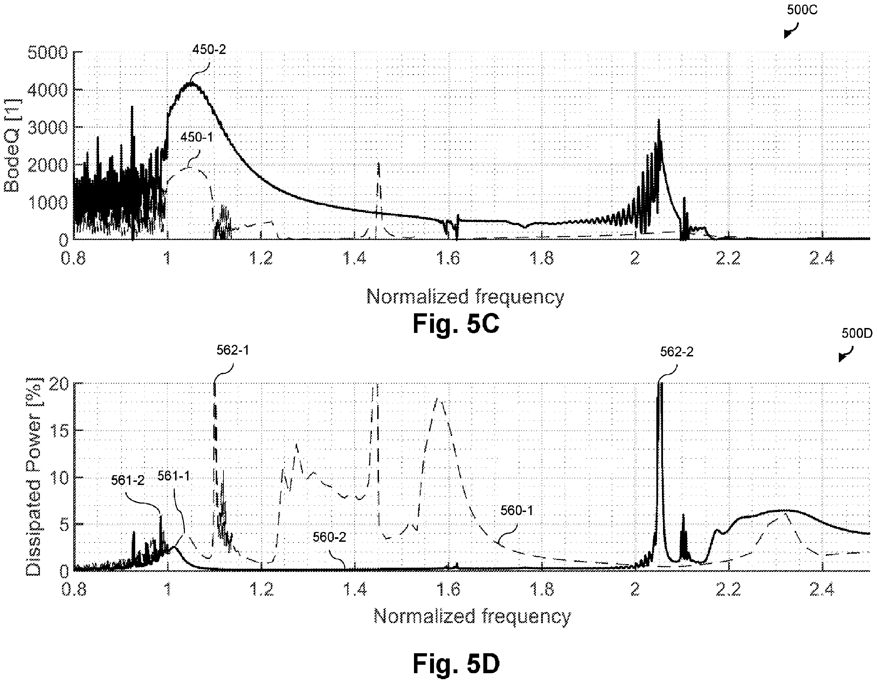

Fig. 5C is a graphical representation of a quality factor of SAW resonators with piezoelectric trenches and heavy-metal electrodes normalized to a common resonance frequency and illustrating extended high-frequency range, according to aspects of the present disclosure. Fig. 5C includes a plot 500C. Plot 500C may be substantially similar to plot 400C of Fig. 4C. For example, plot 500C may include more high frequency content of the same data. As shown in Fig. 5C, the quality factor of the SAW resonator of the data set 450-2 is greater than the quality factor of the data set 450-1.

Fig. 5D is a graphical representation of dissipated power of SAW resonators with piezoelectric trenches and heavy-metal electrodes normalized to a common resonance frequency and illustrating extended high-frequency range, according to aspects of the present disclosure. Fig. 5D includes a plot 500D. The plot 500D includes a dataset 560-1 corresponding to a SAW resonator that does not include heavy metal electrodes or PZTs. The plot 500D also includes a dataset 560-2 corresponding to a SAW resonator that does include both heavy metal electrodes and PZTs (such as the SAW resonator 200 (Fig. 2)).

Data set 560-1 includes a peak 561-1 and a peak 562-1. Data set 560-2 includes a peak 561-2 and a peak 562-2. As shown in Fig. 5D, as the depth of the PZT is increased and/or as the thickness of the heavy metal layer is increased, the peak corresponding to the upper stop band edge (e.g., peak 562-2) may be moved higher along the frequency spectrum.

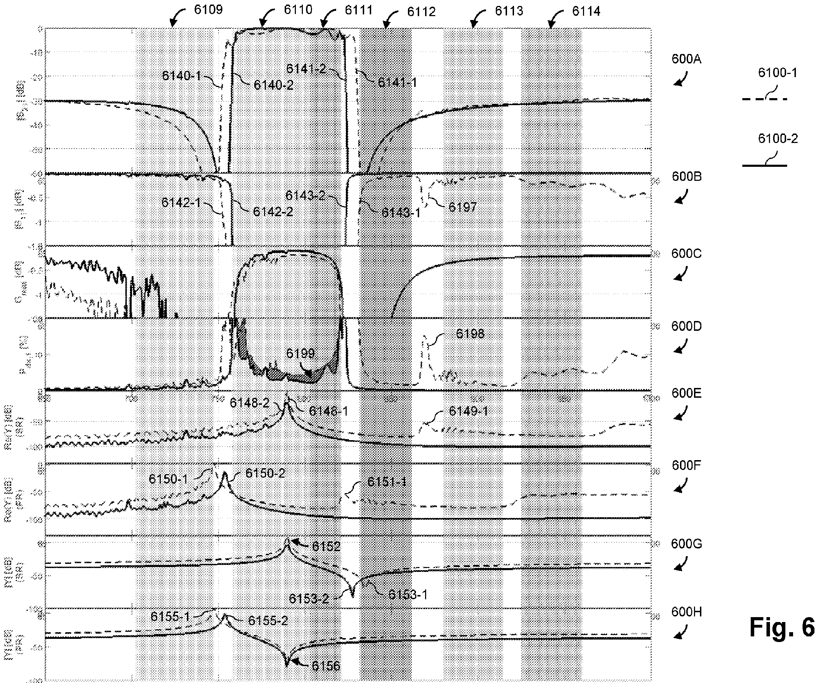

Fig. 6 is a graphical representation of a comparison of the performance of SAW ladder filters including series and parallel resonators, based on resonators with and without piezoelectric trenches and heavy-metal electrodes, according to aspects of the present disclosure. Fig. 6 includes a plot 600A. In some aspects, the plot 600A corresponds to a comparison of a frequency response of a filter, including SAW resonators which do not include PZTs or heavy metal layers with a frequency response of a filter including SAW resonators which include PZTs and heavy metal layers for improved performance. The plots include data 6100-1 corresponding to aspects of a filter with SAW resonators without PZTs or heavy metal layers as well as data 6100-2 corresponding to aspects of a filter with SAW resonators with PZTs and heavy metal layers.

Each of the plots of Fig. 6 also highlight multiple frequency bands for mobile communication. For example, frequency bands 6110 and 6111 are shown corresponding to the passband of the filter, and in some aspects, may correspond to the B28+B20 Rx passbands. Other frequency bands highlighted may correspond to other frequency regions corresponding to filter passbands within a multiplexer circuit or any other suitable circuit. These other bands include band 6109 corresponding to the B28 Tx band, band 6112 corresponding to the B20 Tx band, band 6113 corresponding to the B8 Tx band, and band 6114 corresponding to the B8 Rx band.

As shown in plot 600A, the frequency response of the transmission coefficient corresponding to the filter without PZTs or heavy metal layers includes a lower band edge 6140-1 and an upper band edge 6141-1. The frequency response corresponding to the filter with PZTs and heavy metal layers includes a lower band edge 6140-2 and an upper band edge 6141-2.

The plot 600B also illustrates the reflection coefficient at a port of the filter without PZTs or heavy metal layers compared to the reflection coefficient at the same port of the filter with PZTs and heavy metal layers. A lower band edge 6142-1 may, for example, be aligned in frequency with the lower band edge 6140-1. Similarly, the lower band edge 6142-2 may be aligned in frequency with the lower band edge 6140-2. The upper band edge 6143-1 may be aligned with the upper band edge 6141-1 and the upper band edge 6143-2 may be aligned with the upper band edge 6141-2. The reflection coefficient of the filter without PZTs or heavy metal layers (6100-1) show dips and regions further away from the zero dB level than the filter with PZTs and heavy metal layers (6100-2), which indicate losses and spurious responses which could impact other filters when multiplexed on the same node. The low absolute value of the reflection coefficient close to zero dB for the filter with PZTs and heavy metal layers (6100-2) and the clean response with no dips in reflection coefficient show the benefits for multiplexing such a filter with other filters, such as the ones for bands 6112, 6113 and 6114.

The plot 600C shows the maximum available gain (GMAX) for the transmission of the filters. This is an indication of the loss level of the filters. The higher quality factor of the resonators with PZT and with heavy metal layers lead to a less lossy filter. This can be seen from the fact that GMAX is closer to zero dB for the filter with PZT and with heavy metal layers (6100-2) compared to the filter without PZTs or heavy metal layers (6100-2).

The plot 600D also illustrates the dissipated power of a filter without PZTs or heavy metal layers compared to the dissipated power of the filter with PZTs and heavy metal layers.

As shown in plot 600D, the level of dissipated power of the data set 6100-2 (corresponding to a filter with PZTs and heavy metal layers) is less than the level of the data set 6100-1 (corresponding to a filter without PZTs and heavy metal layers). This difference in magnitude between the data set 6100-2 and the data set 6100-1 is shown by the highlighted region 6199. This shows that the filter with PZTs and heavy metal layers (6100-2) is less lossy than the filter without PZTs or heavy metal layers (6100-2).

The plot 600E shows a conductance of a series resonator within a ladder filter. As shown in Fig. 6, the peak 6148-1 may be aligned with the center of the passband of the filter without PZTs or heavy metal layers shown the plot 600A. Similarly, the peak 6148-2 may be aligned with the center of the passband of the filter with PZTs and heavy metal layers shown in the plot 600A. As shown in plot 600D, the data 600-1 includes a peak 6149-1 corresponding to the upper stop band edge between the passband 6111 and the passband 6112. The peak 6149-1 of plot 600E causes a peak 6198 in dissipated power (plot 600D) as well as a dip 6197 in reflection coefficient (plot 600B), leading to unwanted losses and excitation of specific spurious acoustic modes.

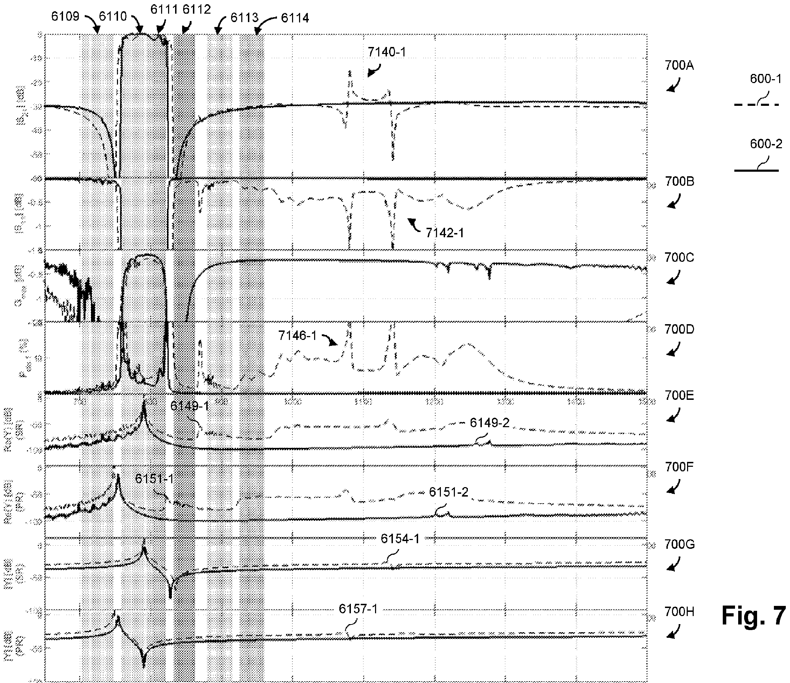

The plot 600F shows a conductance of a parallel resonator within a ladder filter. The data 600-1 includes a peak 6150-1 aligned with the notch in transmission at the lower end of the passband edge 6140-1 of plot 600A. The data 600-2 includes a peak 6150-2 that aligned with the notch in transmission at the lower end of the passband edge 6140-2 of plot 600A. As shown in plot 600F, the data 600-1 also includes a peak 6151-1. The peak 6151-1 may correspond to the upper stop band edge of the resonator without PZTs or heavy metal layers. In some cases, this peak 6151-1 may negatively impact the signal quality of the filter, particularly when falling in the passband of the filter, such as close to the upper band edge. This not only deteriorates the small signal performance, but can also lead to failure when higher powers are applied to the filter. However, as shown in Fig. 6, a filter with SAW resonators that include PZTs and heavy metals shifts this peak significantly higher, as discussed in more detail with reference to Fig. 7.

The plot 600G shows the absolute value of the admittance of a series resonator within a ladder filter. As shown in Fig. 6, the peak 6152 may be aligned with the center of the passband of the filter 600-1 without PZTs or heavy metal layers and the center of the passband of the filter 600-2 with PZTs and heavy metal layers. The peak 6152 may be a -resonance of both data sets 600-1 and 600-2. The data set 600-1 may include an antiresonance 6153-1 aligned with the notch in transmission at the upper end of the passband edge 6141-1 of the plot 600A. The data set 600-2 may include an antiresonance 6153-2 aligned with the notch in transmission at the upper end of the passband edge 6141-2 of the plot 600A.

The plot 600H shows the absolute value of the admittance of a parallel resonator within a ladder filter. Resonance frequencies or peaks 6155-1 and 6155-2 correspond to the notches in transmission at the lower end of the passband edges 6140-1 and 6140-2 respectively of the plot 600A. Both data sets 600-1 and 600-2 may include an antiresonance 6156 aligned with the center of the passband of the plot 600A.

Fig. 7 is a graphical representation of a comparison of the performance of SAW ladder filters including series and parallel resonators, based on resonators with and without piezoelectric trenches and heavy-metal electrodes illustrating extended high-frequency range, according to aspects of the present disclosure.

The plot 700A illustrates the frequency response of the transmission coefficients of the filters of plot 600A with an extended high-frequency range. This extended range reveals spurious content 7140-1 of the data set 600-1 corresponding to a filter with resonators that do not include PZTs or heavy metal layers. The data set 600-2 includes similar spurious content, however, as shown in plot 700A, it is shifted much higher in frequency that it is not captured in the range shown. This advantageously enhances the performance of the resonator with PZTs and heavy metal layers, including by expanding the types of multiplexing filters the resonator may be applied to.

The plot 700B illustrates the reflection coefficient of the filters of plot 600B with an extended high-frequency range. This extended range reveals spurious content 7142-1 of the data set 600-1 corresponding to a filter with resonators that do not include PZTs or heavy metal layers. The data set 600-2 includes similar spurious content, however, as shown in plot 700B, it is shifted much higher in frequency that it is not captured in the range shown. As explained previously, this advantageously enhances the performance of the resonator with PZTs and heavy metal layers, including by expanding the types of multiplexing filters the resonator may be applied to.

The plot 700C shows the maximum available gain (GMAX) for the transmission of the filters with an extended high-frequency range.

The plot 700D illustrates the dissipated power of the filters of plot 600D with an extended high-frequency range. This extended range reveals spurious content 7146-1 of the data set 600-1 corresponding to a filter with resonators that do not include PZTs or heavy metal layers. The data set 600-2 includes similar spurious content, however, as shown in plot 700B, it is shifted much higher in frequency that it is not captured in the range shown. As shown in Fig. 7, the spurious content 7146-1, 7142-1, and 7140-1 may be aligned.

The plot 700E illustrates the conductance of the series resonators described with reference to plot 600E with an extended high-frequency range. As shown in Fig. 7, the data set 600-1 includes a peak 6149-1 between the passband 6112 and the passband 6113. This peak 6149-1 may correspond to spurious content of the series resonator, namely the upper stop band edge. Accordingly, as a filter is designed, the series resonator must be configured such that the peak 6149-1 may be between passbands as shown, in order to limit the amount of multiplexing losses which may limit the applications of the resonator.

In contrast, the data set 600-2 includes a corresponding peak 6149-2. As shown, this peak 6149-2 is well above all of the passbands shown in frequency, which ensures that the series resonator may be used in the greatest variety of filters and enables easy multiplexing of various bands on the same node. In addition, as shown, the overall amplitude of the out of band content of the data set 600-2, including the peak 6149-2, is greatly reduced compared to the data set 600-1. This also contributes to less losses and an increased performance of the filter.

The plot 700F illustrates the conductance of the parallel resonators described with reference to plot 600F with an extended high-frequency range. As shown in Fig. 7, the data set 600-1 includes a peak 6151-1 between the passband 6111 and the passband 6112. This peak 6151-1 may correspond to spurious content of the series resonator, namely the upper stop band edge. Accordingly, as a filter is designed, the series resonator must be configured such that the peak 6151-1 may be between passbands as shown which may limit the applications of the resonator. The upper stop band edge is so close to the upper band edge of the passband of the filter for the combined bands 6110 + 6111 that it is challenging to design a filter where the upper stop band edge will not impact the filter performance at the upper band edge.

In contrast, the data set 600-2 includes a corresponding peak 6151-2. As shown, this peak 6151-2 is well above all of the passbands shown in frequency, which ensures that the series resonator may be used in the greatest variety of filters. In addition, as shown, the overall amplitude of the out of band content of the data set 600-2, including the peak 6151-2, is greatly reduced compared to the data set 600-1. This also contributes to less losses and an increased performance of the filter. The plot 700G illustrates the absolute value of the admittance of the series resonator described with reference to plot 600G with an extended high-frequency range. This extended range reveals spurious content 6154-1 of the data set 600-1 corresponding to a filter with resonators that do not include PZTs or heavy metal layers. The data set 600-2 includes similar spurious content, however, as shown in plot 700G, it is shifted much higher in frequency that it is not captured in the range shown. This advantageously enhances the performance of the resonator with PZTs and heavy metal layers, including by expanding the types of multiplexing cases between various sets of filters the resonator may be applied to.

The plot 700H shows the absolute value of the admittance of the parallel resonator described with reference to plot 600H with an extended high-frequency range. This extended range reveals spurious content 6157-1 of the data set 600-1 corresponding to a filter with resonators that do not include PZTs or heavy metal layers. The data set 600-2 includes similar spurious content, however, as shown in plot 700H, it is shifted much higher in frequency that it is not captured in the range shown. This advantageously enhances the performance of the resonator with PZTs and heavy metal layers, including by expanding the types of multiplexing cases between various sets of filters the resonator may be applied to.

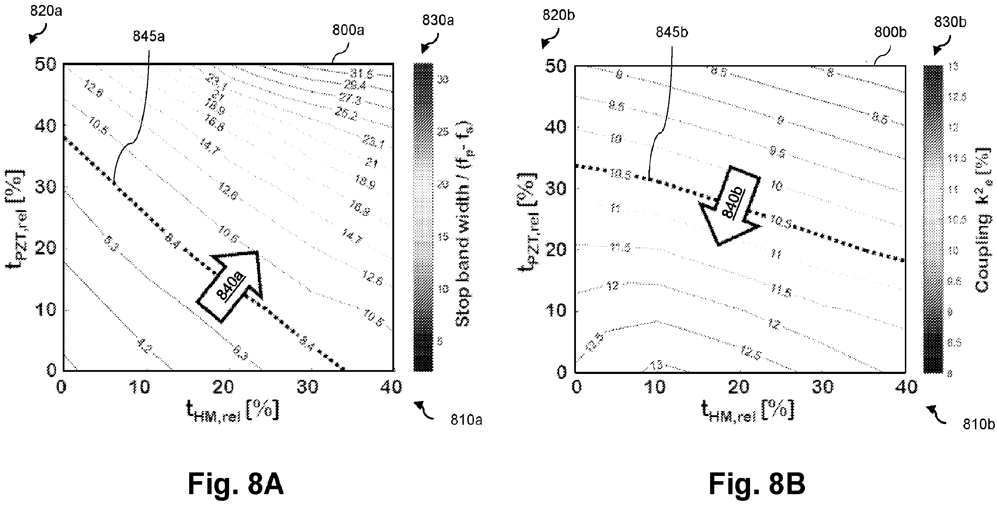

Fig. 8A is a graphical representation of a relationship between heavy metal layer thickness, piezoelectric trench depth, and stop band width of a SAW resonator, according to aspects of the present disclosure.

Fig. 8A includes a plot 800a. The plot 800a includes an x-axis 810a corresponding to the relative thickness of the heavy metal layer of an electrode within a SAW resonator, a y-axis 820a corresponding to the relative depth of a PZT, and a scale 830a corresponding to stop band width. In some aspects, the thickness of the heavy metal layers as well as the depth of piezoelectric trenches may be quantified nominally (i.e., in units of actual thickness or depth) or may be quantified relatively (i.e., relative to the thickness of the piezoelectric layer). In that regard, when the terms "thickness" and "depth" are used herein, it may refer to either nominal or relative thickness or depth. In some aspects, the stop band width of a SAW resonator may ideally be maximized. In some aspects, piezoelectric trench depth may be quantified as a percentage of trench depth compared to thickness of the piezoelectric layer 260 (Fig. 2). For example, a value of 0% corresponds to no trench and a value of 100% may correspond to a fully etched trench such that the depth of the trench is equal to the thickness 260 of the piezoelectric layer (Fig. 2). Heavy metal layer thickness may be quantified as a percentage as well. For example, the thickness of the heavy metal layer may be conveyed as a percentage of the heavy metal layer thickness and the thickness 260 of the piezoelectric layer, which, by way of a non-limiting example, may be 500 nm.

As shown in the plot 800a, as trench depth is increased, and as heavy metal layer thickness is increased, the stop band width also increases. The direction of this increase in stop band width is illustrated by the arrow 840a as well as by the labeled plot lines. The dotted line 845a may identify the minimum ideal stop band width of the resonator. For example, a SAW resonator may ideally be designed by selecting the heavy metal layer thickness and piezoelectric trench depth such that the resulting coordinates lie on the side of the line 845a indicated by the arrow 840a.

Fig. 8B is a graphical representation of a relationship between heavy metal layer thickness, piezoelectric trench depth, and coupling of a SAW resonator, according to aspects of the present disclosure.

Fig. 8B includes a plot 800b. The plot 800b includes an x-axis 810b corresponding to the thickness of the heavy metal layer of an electrode within a SAW resonator, a y-axis 820b corresponding to the depth of a PZT, and a scale 830b corresponding to coupling. In some aspects, the coupling of a SAW resonator may ideally be maximized. As shown in the plot 800b, as trench depth is increased, and as heavy metal layer thickness is increased, the coupling decreases. The arrow 840b shown in Fig. 8B as well as the labeled plot lines illustrate the direction of increase of coupling. The dotted line 845b may identify the minimum ideal coupling of the resonator. For example, a SAW resonator may ideally be designed by selecting the heavy metal layer thickness and piezoelectric trench depth such that the resulting coordinates lie on the side of the line 845b indicated by the arrow 840b.

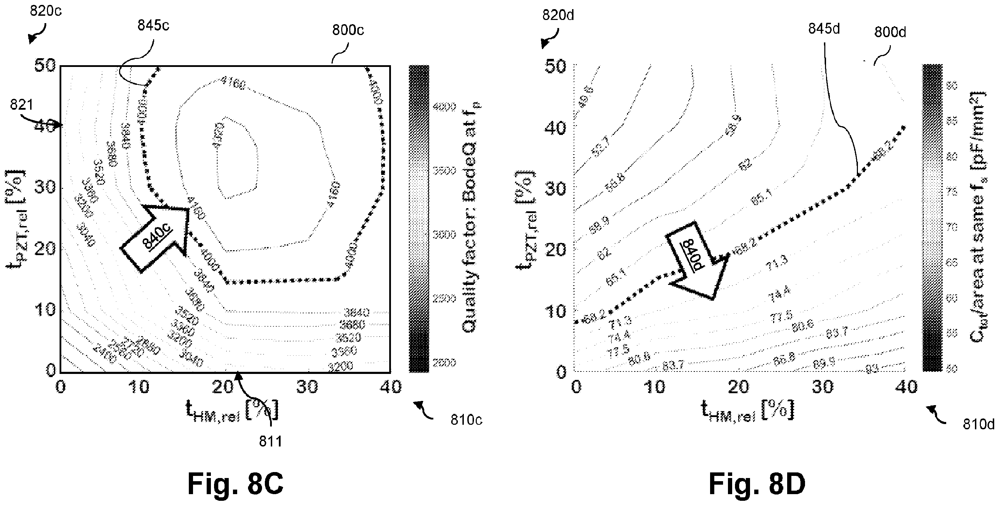

Fig. 8C is a graphical representation of a relationship between heavy metal layer thickness, piezoelectric trench depth, and quality factor of a SAW resonator, according to aspects of the present disclosure.

Fig. 8C includes a plot 800c. The plot 800c includes an x-axis 810c corresponding to the thickness of the heavy metal layer of an electrode within a SAW resonator, a y-axis 820c corresponding to the depth of a PZT, and a scale 830c corresponding to quality factor. In some aspects, the quality factor of a SAW resonator may ideally be maximized. As shown in the plot 800c, the quality factor of the resonator increases towards a maximum point identified by the plot line corresponding to a quality factor 4320. The dotted line 845c may identify the minimum ideal quality of the resonator. For example, a SAW resonator may ideally be designed by selecting the heavy metal layer thickness and piezoelectric trench depth such that the resulting coordinates lie on the side of the line 845c indicated by the arrow 840c.

As previously described, the combination of piezoelectric trenches and heavy metal layers provides an unexpected increase in quality factor for SAW resonators, as shown in Fig. 8C. For example, as the trench depth is increased (shown by the y-axis 820c), the quality factor increases to about a point 821, after which the quality factor begins to decrease. Persons of ordinary skill in the art presently do not expect that introducing a heavy metal layer to the electrodes after implementing and increasing the depth of the PZTs to the point 821 will have any positive effect on quality factor, but would cause a decrease in quality factor. However, contrary to the current expectations, as shown in Fig. 8C, as a heavy metal layer is included within SAW resonator electrodes (shown by the x-axis 810c), the quality factor can be additionally increased to a point 811, significantly increasing the quality factor of the SAW resonator beyond what was previously thought (i.e., BodeQ at fp increases from a maximum about 3100 to above 4320).

Fig. 8D is a graphical representation of a relationship between heavy metal layer thickness, piezoelectric trench depth, and capacitance per area of a SAW resonator, according to aspects of the present disclosure.

Fig. 8D includes a plot 800d. The plot 800d includes an x-axis 810d corresponding to the thickness of the heavy metal layer of an electrode within a SAW resonator, a y-axis 820d corresponding to the depth of a PZT, and a scale 830d corresponding to capacitance per area for resonators at the same resonance frequency fs. In some aspects, the capacitance per area of a SAW resonator may ideally be maximized. With higher capacitance per area a resonator with a specific capacitance target can be realized within a smaller area, which can be beneficial for shrinking acoustic filters. As shown in the plot 800d, as trench depth is increased the capacitance per area decreases. In contrast, as heavy metal layer thickness is increased, the capacitance per area increases. The direction of this shift in capacitance is illustrated by the arrow 840d as well as by the labeled plot lines. The dotted line 845d may identify the minimum ideal capacitance per area of the resonator. For example, a SAW resonator may ideally be designed by selecting the heavy metal layer thickness and piezoelectric trench depth such that the resulting coordinates lie on the side of the line 845d indicated by the arrow 840d.

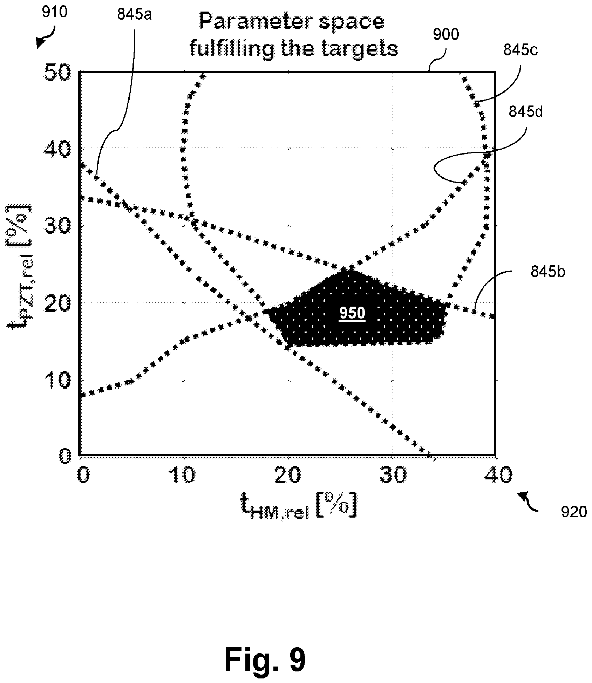

Fig. 9 is a graphical representation of a plot illustrating ideal piezoelectric trench depth and heavy metal layer thickness, according to aspects of the present disclosure. In that regard, selecting piezoelectric trench depth and heavy metal layer thickness may include tradeoffs between ideal parameters. As shown in Fig. 9, the plot 900 may include the line 845a illustrating the minimum ideal stop band width, the line 845b illustrating the minimum ideal coupling, the line 845c illustrating the minimum ideal quality factor, and the line 845d illustrating the minimum capacitance per area. Plot 900 illustrates a region 950 highlighted to identify the regions of the plot in which all four of the parameters of plots 800a-d are optimized. In that regard, the piezoelectric trench depth and heavy metal layer thickness of a SAW resonator may ideally be selected such that the resulting coordinates falls within the region 950 of the plot 900.

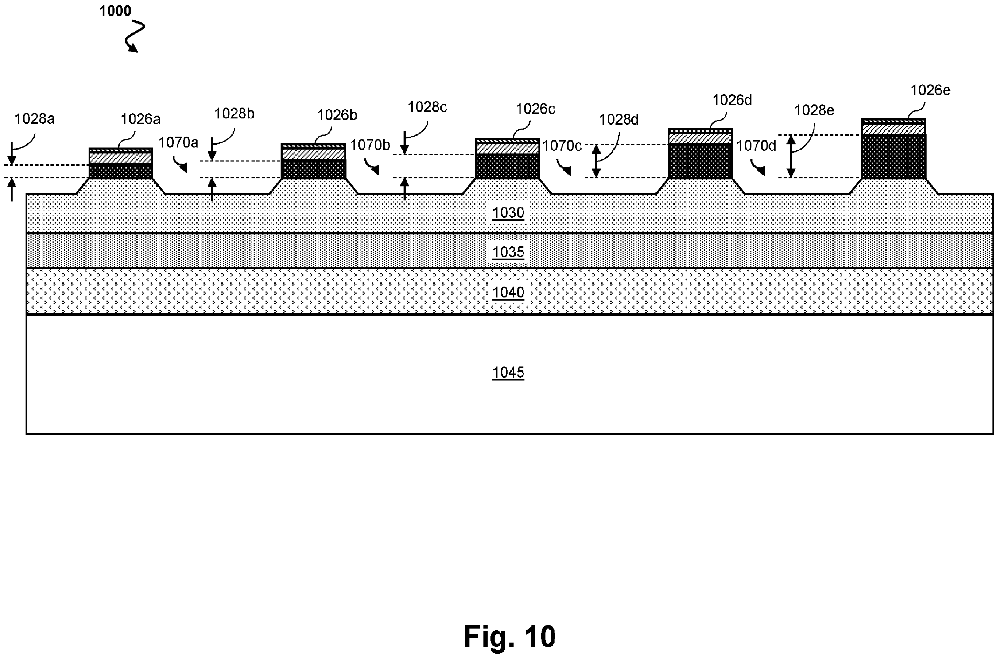

Fig. 10 is a cross-sectional side view of a SAW resonator 1000 with a piezoelectric trench and heavy metal electrodes wherein the thickness of the heavy metal layers is varied between electrodes, according to aspects of the present disclosure.

As shown previously, a SAW resonator may include spurious content above and below the fundamental resonance frequency. This leads to spurious content outside the passband of a filter which may interfere with the pass bands of other filters. Modulating the thickness of the heavy metal layers of different electrodes within a SAW resonator, as shown in Fig. 10 may advantageously reduce the amplitude of spurious content. In some aspects, the amplitude of spurious content may additionally be decreased by varying or modulating the pitch between electrodes (i.e., the distance between electrodes) as well as by modulating the depth of piezoelectric trenches. In that regard, by modulating any of these parameters (heavy metal layer thickness, pitch, and piezoelectric trench depth), some electrodes may provide advantages at the expense of other performance metrics while others provide different advantages. For example, some electrodes within a SAW resonator may be designed to achieve moderate stop band width while providing ideal coupling, while other electrodes within the same SAW resonator may be designed to achieve ideal stop band width with moderate coupling. This type of variation in electrodes may be implemented between different filters on the same die, between different groups of resonators within the same filter (e.g., series resonators or parallel resonators, also known as shunt resonators), or between different electrodes within the same resonator.

In the example shown, the SAW resonator 1000 includes a carrier substrate 1045, a dielectric layer 1040, a dielectric layer 1035, and a piezoelectric film 1030. The SAW resonator includes electrodes 1026a, 1026b, 1026c, 1026d, and 1026e. Each of these electrodes includes heavy metal layers of differing thicknesses. For example, the electrode 1026a includes a heavy metal layer of a thickness 1028a. The electrode 1026b includes a heavy metal layer of a thickness 1028b, greater than 1028a. The electrode 1026c includes a heavy metal layer of a thickness 1028c, greater than 1028a. The electrode 1026d includes a heavy metal layer of a thickness 1028d, greater than 1028a.

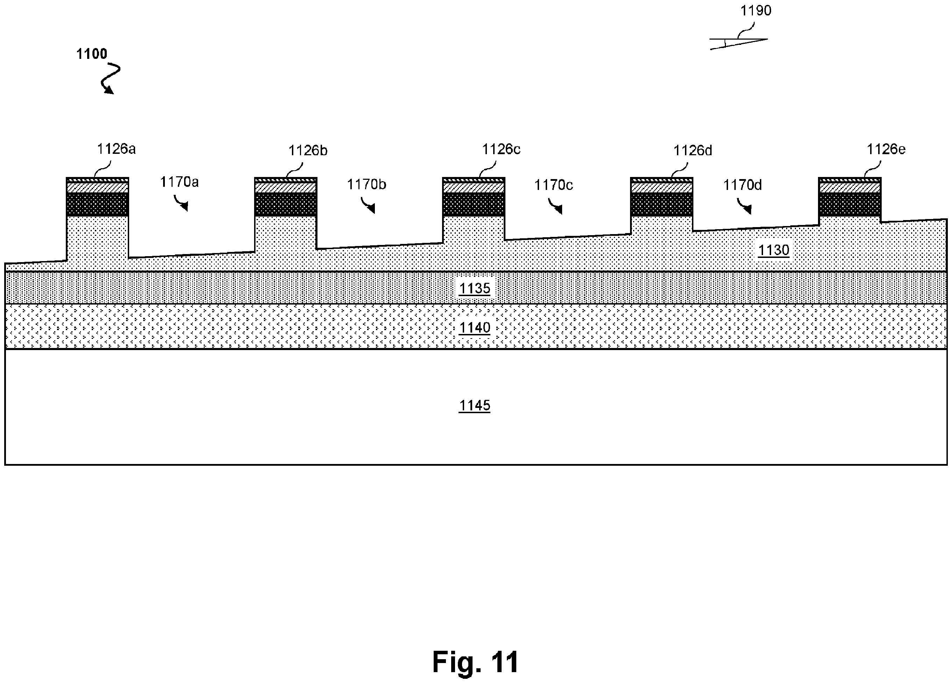

Fig. 11 is a cross-sectional side view of a SAW resonator with piezoelectric trenches and heavy metal electrodes wherein the depth of the piezoelectric trenches is modulated, according to aspects of the present disclosure. In some aspects, the depth of piezoelectric trenches between electrodes may be varied by providing a continuous angled top surface of the piezoelectric trenches formed within the piezoelectric layer 1130.

For example, the SAW resonator 1100 includes a carrier substrate 1145, a dielectric layer 1140, a dielectric layer 1135, and a piezoelectric film 1130. The SAW resonator includes electrodes 1126a, 1126b, 1126c, 1126d, and 1126e. A piezoelectric trench is positioned between each of the electrodes 1126a. For example, a piezoelectric trench 1170a is shown between the electrodes 1126a and 1126b. A piezoelectric trench 1170b is shown between the electrodes 1126b and 1126c. A piezoelectric trench 1170c is shown between the electrodes 1126c and 1126d. A piezoelectric trench 1170d is shown between the electrodes 1126d and 1126e.

As shown, the depth of the piezoelectric trenches 1170 may be varied or modulated. This variation of the piezoelectric trench depth may be achieved due to the top surface of the piezoelectric layer 1135 being angled, for example, by an angle 1190. In some aspects, this modulation of the piezoelectric trench depth may provide a number of advantages. For example, PZTs of lesser thickness may correspond to regions of the resonator of higher capacitance per area, while PZTs of greater thickness correspond to regions of greater reflectivity. Thus, having PZTs of both greater and lesser depths may provide both advantages within the same resonator. In addition, this trench depth modulation may provide more continuity from unit cell to unit cell, leading to less scattering.

Thus, from one perspective, there has been described a surface acoustic wave (SAW) resonator device. The SAW resonator device includes a first electrode positioned on an upper surface of a piezoelectric film. The first electrode may include a plurality of layers wherein a layer of the plurality of layers is a first heavy metal layer. The SAW resonator device may also include a first piezoelectric trench (PZT) positioned adjacent to the first electrode. The first PZT includes a recess in the piezoelectric film.

Persons skilled in the art will recognize that the apparatus, systems, and methods described above can be modified in various ways. Accordingly, persons of ordinary skill in the art will appreciate that the embodiments encompassed by the present disclosure are not limited to the particular example embodiments described above. In that regard, although illustrative embodiments have been shown and described, a wide range of modification, change, and substitution is contemplated in the foregoing disclosure. It is understood that such variations may be made to the foregoing without departing from the scope of the present disclosure. Accordingly, it is appropriate that the appended claims be construed broadly and in a manner consistent with the present disclosure.

Further examples of feature combinations taught by the present disclosure are set out in the following numbered clauses:
1. A surface acoustic wave (SAW) resonator device, comprising:
   a first electrode positioned on an upper surface of a piezoelectric film, the first electrode comprising a plurality of layers wherein a layer of the plurality of layers is a first heavy metal layer; and
   a first piezoelectric trench (PZT) positioned adjacent to the first electrode, the first PZT including a recess in the piezoelectric film.
2. The SAW resonator device of clause 1, wherein the heavy metal layer of the first electrode is made of platinum.
3. The SAW resonator device of clause 1, wherein the heavy metal layer of the first electrode is made of tungsten.
4. The SAW resonator device of clause 1, wherein the heavy metal layer of the first electrode is made of gold.
5. The SAW resonator device of any preceding clause, wherein the first electrode further comprises a second heavy metal layer.
6. The SAW resonator device of clause 5, wherein the first heavy metal layer and the second heavy metal layer are separated by a conductive layer.
7. The SAW resonator device of any preceding clause, wherein the first PZT is positioned between the first electrode and a second electrode positioned on the upper surface of the piezoelectric film.
8. The SAW resonator device of any preceding clause, further comprising a second electrode including a second heavy metal layer.
9. The SAW resonator device of clause 8, wherein the second electrode includes a third heavy metal layer.
10. The SAW resonator device of any preceding clause, wherein the first PZT is an upper PZT formed within the upper surface of the piezoelectric film.
11. The SAW resonator device of any of clauses 1 to 9, wherein the first PZT is a lower PZT formed within the lower surface of the piezoelectric film.
12. The SAW resonator device of any preceding clause, wherein a first trench depth of the first PZT is equal to or less than the thickness of the piezoelectric film.
13. The SAW resonator device of clause 12, wherein a trench depth equal to the thickness of the piezoelectric film corresponds to a fully-etched PZT.
14. The SAW resonator device of any preceding clause, further comprising a second PZT positioned within the piezoelectric film on a side of the first electrode opposite the first PZT.
15. A surface acoustic wave (SAW) resonator device, comprising:
   a plurality of electrodes positioned on an upper surface of a piezoelectric film of a first thickness, each electrode of the plurality of electrodes comprising at least one heavy metal layer; and
   a plurality of piezoelectric trenches (PZTs) formed within the piezoelectric film between the plurality of electrodes, wherein the plurality of PZTs correspond to regions of the piezoelectric film of a second thickness less than the first thickness.
16. The SAW resonator device of clause 15, wherein the plurality of electrodes are spaced from one another by a first pitch and the plurality of PZTs are spaced from one another by a second pitch.
17. The SAW resonator device of clause 16, wherein the first pitch is different from the second pitch.
18. The SAW resonator device of any of clauses 15 to 17, wherein the plurality of electrodes are spaced from one another by a modulated pitch, such that a first subset of two or more electrodes are spaced from one another by a first pitch and a second subset of two or more interdigital transducers are spaced from one another by a second pitch.
19. A method, comprising:
   receiving a surface acoustic wave (SAW) resonator device, the device comprising:
      a piezoelectric film;
      an interdigital transducer including a plurality of interleaved electrodes positioned on the piezoelectric film, each electrode of the plurality of interleaved electrodes comprising a heavy metal layer; and
      a sacrificial layer positioned on the plurality of interleaved electrodes; and
   applying an ion beam to the upper surface of the SAW resonator device such that the sacrificial layer is removed and forming piezoelectric trenches (PZTs) between the plurality of interleaved electrodes.
20. The method of clause 19, further comprising:
   patterning the plurality of interleaved electrodes on the piezoelectric film; and
   patterning the sacrificial layer on the plurality of interleaved electrodes.
21. The method of clause 19 or clause 20, wherein the interleaved electrodes and sacrificial material are patterned by sputtering, lithography, and dry etching.

## Claims

1. A surface acoustic wave (SAW) resonator device, comprising:
a first electrode positioned on an upper surface of a piezoelectric film, the first electrode comprising a plurality of layers wherein a layer of the plurality of layers is a first heavy metal layer; and
a first piezoelectric trench (PZT) positioned adjacent to the first electrode, the first PZT including a recess in the piezoelectric film.

2. The SAW resonator device of claim 1, wherein the heavy metal layer of the first electrode is made of platinum, tungsten or gold.

3. The SAW resonator device of any preceding claim, wherein the first electrode further comprises a second heavy metal layer, for example wherein the first heavy metal layer and the second heavy metal layer are separated by a conductive layer.

4. The SAW resonator device of any preceding claim, wherein the first PZT is positioned between the first electrode and a second electrode positioned on the upper surface of the piezoelectric film.

5. The SAW resonator device of any preceding claim, further comprising a second electrode including a second heavy metal layer, for example wherein the second electrode includes a third heavy metal layer.

6. The SAW resonator device of any preceding claim, wherein the first PZT is an upper PZT formed within the upper surface of the piezoelectric film.

7. The SAW resonator device of any of claims 1 to 5, wherein the first PZT is a lower PZT formed within the lower surface of the piezoelectric film.

8. The SAW resonator device of any preceding claim, wherein a first trench depth of the first PZT is equal to or less than the thickness of the piezoelectric film, for example wherein a trench depth equal to the thickness of the piezoelectric film corresponds to a fully-etched PZT.

9. The SAW resonator device of any preceding claim, further comprising a second PZT positioned within the piezoelectric film on a side of the first electrode opposite the first PZT.

10. A surface acoustic wave (SAW) resonator device, comprising:
a plurality of electrodes positioned on an upper surface of a piezoelectric film of a first thickness, each electrode of the plurality of electrodes comprising at least one heavy metal layer; and
a plurality of piezoelectric trenches (PZTs) formed within the piezoelectric film between the plurality of electrodes, wherein the plurality of PZTs correspond to regions of the piezoelectric film of a second thickness less than the first thickness.

11. The SAW resonator device of claim 10, wherein the plurality of electrodes are spaced from one another by a first pitch and the plurality of PZTs are spaced from one another by a second pitch, for example wherein the first pitch is different from the second pitch.

12. The SAW resonator device of claim 10 or claim 11, wherein the plurality of electrodes are spaced from one another by a modulated pitch, such that a first subset of two or more electrodes are spaced from one another by a first pitch and a second subset of two or more interdigital transducers are spaced from one another by a second pitch.

13. A method, comprising:
receiving a surface acoustic wave (SAW) resonator device, the device comprising:
a piezoelectric film;
an interdigital transducer including a plurality of interleaved electrodes positioned on the piezoelectric film, each electrode of the plurality of interleaved electrodes comprising a heavy metal layer; and
a sacrificial layer positioned on the plurality of interleaved electrodes; and
applying an ion beam to the upper surface of the SAW resonator device such that the sacrificial layer is removed and forming piezoelectric trenches (PZTs) between the plurality of interleaved electrodes.

14. The method of claim 13, further comprising:
patterning the plurality of interleaved electrodes on the piezoelectric film; and
patterning the sacrificial layer on the plurality of interleaved electrodes.

15. The method of claim 13 or claim 14, wherein the interleaved electrodes and sacrificial material are patterned by sputtering, lithography, and dry etching.
